(19) Europäisches Patentamt / European Patent Office / Office européen des brevets

(11) **EP 3 285 124 B1**

(12) **FASCICULE DE BREVET EUROPEEN**

(45) Date de publication et mention de la délivrance du brevet:
**16.12.2020 Bulletin 2020/51**

(21) Numéro de dépôt: **16184620.9**

(22) Date de dépôt: **17.08.2016**

(51) Int Cl.:
*G04B 17/28* (2006.01)  *G04B 17/22* (2006.01)
*G04B 17/06* (2006.01)  *C30B 29/06* (2006.01)
*C30B 33/00* (2006.01)  *C30B 33/06* (2006.01)

(54) **RÉSONATEUR MÉCANIQUE POUR PIÈCE D'HORLOGERIE AINSI QUE PROCÉDÉ DE RÉALISATION D'UN TEL RÉSONATEUR**

MECHANISCHER RESONATOR FÜR UHRWERK, SOWIE HERSTELLUNGSVERFAHREN EINES SOLCHEN RESONATORS

MECHANICAL RESONATOR FOR TIMEPIECE AND METHOD FOR MANUFACTURING SUCH A RESONATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**21.02.2018 Bulletin 2018/08**

(73) Titulaire: **Tronic's Microsystems S.A**
**38920 Crolles (FR)**

(72) Inventeurs:
• **Tobenas, Susana**
  **2017 Boudry (CH)**
• **Fiaccabrino, Jean-Charles**
  **1421 Grandevent (CH)**
• **Gaff, Vincent**
  **38320 Brie (FR)**
• **Visse, Pierre-Marie**
  **38100 Grenoble (FR)**
• **Ribetto, Luca**
  **38500 Voiron (FR)**

(74) Mandataire: **Cabinet Laurent & Charras**
**Le Contemporain**
**50 Chemin de la Bruyère**
**69574 Dardilly Cedex (FR)**

(56) Documents cités:
EP-A1- 2 075 222  EP-A1- 3 088 969
EP-A1- 3 256 910  WO-A1-2015/087252
WO-A2-2015/011637  CH-A2- 699 780
CH-B1- 708 067  FR-A1- 3 032 810

## Description

Domaine technique

L'invention concerne un résonateur mécanique destiné à équiper un organe régulateur d'une pièce d'horlogerie ainsi qu'un procédé de fabrication d'un tel résonateur.

L'invention trouve une application particulièrement avantageuse pour les résonateurs avec symétrie radiale oscillant en « breathing mode ». Plus spécifiquement l'invention trouve une application particulièrement avantageuse pour les spiraux destinés à équiper le balancier d'un ensemble d'horlogerie mécanique telle qu'une montre.

Etat de la technique

Les mouvements de montres mécaniques sont régulés au moyen d'un régulateur mécanique comprenant un résonateur, c'est-à-dire un composant déformable élastiquement et dont les oscillations déterminent la marche de la montre. De nombreuses montres comportent par exemple un régulateur comprenant un spiral comme résonateur, monté sur l'axe d'un balancier et mis en oscillation grâce à un échappement; la fréquence propre du couple balancier-spiral permet de réguler la montre. D'autres types de résonateurs connus sont basés par exemple sur des diapasons, des barreaux oscillants, ou d'autres éléments mécaniques.

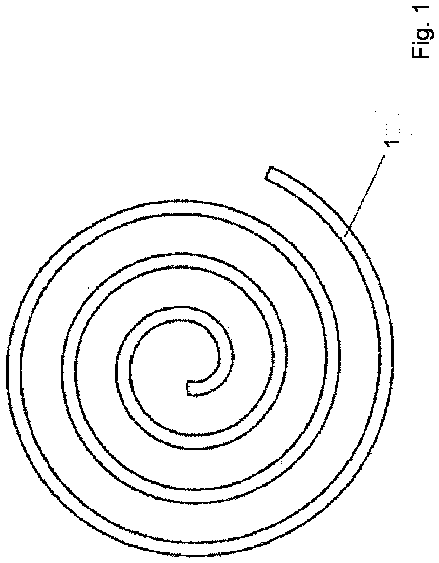

Un exemple de résonateur spiral 1 est illustré sur la figure 1. La raideur d'un résonateur de type spiral est donnée par :

$$K = \frac{M}{\varphi}$$

avec :

$\varphi$, l'angle de torsion du ressort et
$M$, le couple de rappel du ressort spiral.

L'équation de ce couple de rappel pour un barreau constitué d'un matériau spécifique est donné par :

$$M = \frac{E\left(\frac{w^3 t}{12}\varphi\right)}{L}$$

avec :

$E$, le module d'Young du matériau employé pour le barreau,
$L$, la longueur du barreau,
$w$, la largeur du barreau, et
$t$, l'épaisseur du barreau.

La fréquence propre de résonance du spiral est proportionnelle à la racine carrée de sa raideur. Par conséquent, la fréquence du spiral est proportionnelle à la racine carrée du module d'Young du matériau. Donc, si le module d'Young varie en fonction de la température, la fréquence du spiral va également varier en fonction de la température. Pour une faible variation en température, la fréquence du spiral dépend donc au premier ordre de la variation en température du module d'Young.

Il est ainsi admis que l'équation suivante montre les variations du module d'Young en fonction de la température :

$$E = E_0\big(1 + \propto_E (T - T_0)\big)$$

avec :

$\propto_E$, le coefficient thermique du module d'Young,
$E$, le module d'Young à la température $T$, et
$E_0$, le module d'Young à la température $T_0$.

Afin de conserver une fréquence d'oscillation stable même en cas de variations de température, et donc de maintenir l'isochronisme, il est connu de réaliser des spiraux ou d'autres types de résonateurs mécaniques dans un métal tel que l'élinvar qui est caractérisé par un module d'Young extrêmement stable en fonction de la température.

Il est également connu de réaliser des résonateurs par gravure d'un wafer de silicium qui peuvent être usinés avec une très haute précision par des procédés de photolithographie. Les procédés de réalisation de ces résonateurs mécaniques utilisent généralement des wafers de silicium monocristallin. Le silicium monocristallin appartient en effet à la classe cristalline cubique m3m dont le coefficient d'expansion thermique (alpha) est totalement isotrope.

Le silicium présente une valeur du premier coefficient thermoélastique très négative, proche de -64 ppm/C. Par conséquent, la raideur d'un résonateur en silicium, et donc sa fréquence propre, varie fortement selon la température. Un résonateur mécanique en silicium pur est donc anisochrone.

Afin de compenser au moins partiellement cet inconvénient, EP1422436 suggère un résonateur mécanique de type spiral réalisé à partir d'une âme en silicium monocristallin et dont les variations en température du module d'Young sont compensées par une couche entourant l'âme et réalisée dans un matériau ayant un premier coefficient thermoélastique de signe opposé à celui du silicium. De préférence, la couche externe est réalisée en SiO2 amorphe, un des rares matériaux présentant un coefficient thermoélastique positif (+213 ppm/C).

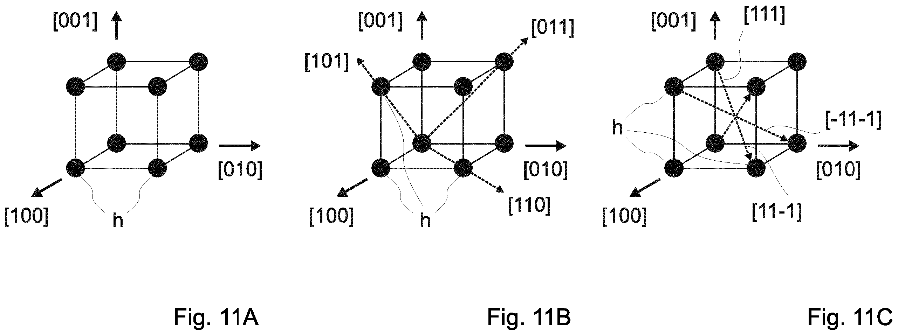

Ce document EP1422436 suggère un spiral en silicium obtenu à partir d'un wafer coupé selon le plan cristallin {001}. La figure 11A illustre ce plan, et deux plans équivalents {010} et {100}, dans le cas d'un cristal à face cubique. Le réseau du silicium est à face cubique centrée et comporte donc six nœuds supplémentaires au centre de chacune des faces de ce cube, qui ne sont pas représentées sur les figures 11A à 11C pour la simplification de la figure; la définition des plans cristallins est cependant identique.

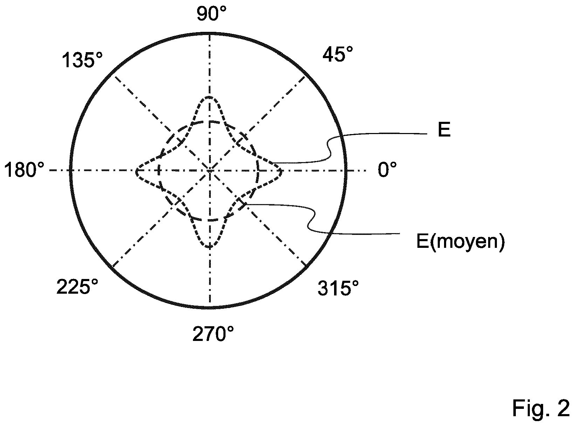

La coupe {001} présente un facteur d'anisotropie planaire relativement élevé. La situation est illustrée sur la figure 2 qui montre la valeur du module d'Young E (rigidité à la flexion) selon différentes directions dans le plan du spiral, ainsi que la valeur moyenne E(moyen) de ce module (environ 148 GPa)

Cela se traduit par une rigidité à la flexion (module d'Young) qui varie significativement en fonction de la direction. En raison de cette anisotropie, un résonateur spiral oscillant en breathing mode et gravé dans un wafer coupé selon le plan {001} a un développement non concentrique, ce qui perturbe la chronométrie et l'esthétique.

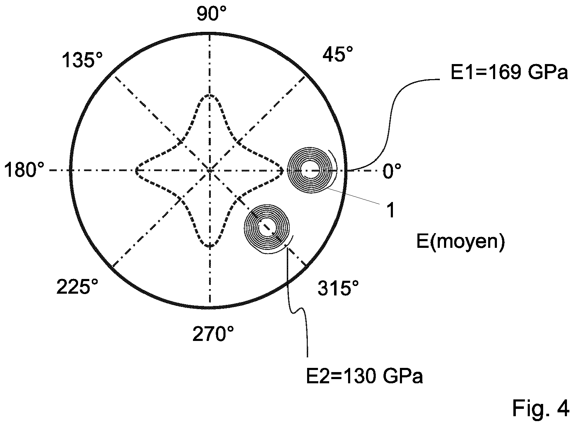

L'anisotropie du module d'Young planaire d'un résonateur gravé dans un wafer coupé selon le plan {001} est également gênante si l'on veut maitriser correctement la raideur équivalente d'un résonateur de forme complexe lors de sa phase de conception. En effet, pour obtenir une bonne corrélation entre les valeurs calculées et les valeurs mesurées pour la raideur équivalente, on doit tenir compte notamment de l'orientation précise des éléments du résonateur qui ne présentent pas une symétrie parfaitement radiale par rapport aux différentes directions planaires du wafer. Par exemple les courbes terminales de deux spiraux orientés différemment dans un wafer coupé selon le plan {001} verront un module d'Young en flexion significativement différent et en conséquence leur raideurs équivalentes seront aussi significativement différentes, comme illustré schématiquement sur la figure 4.

Il est aussi à noter que les modes de vibration autres que fondamentaux sont des sources de dissipation d'énergie. Les mouvements non concentriques d'un spiral provoquent le déplacement des pivots de balancier dans les pierres et augmentent par voie de conséquence les forces de frottement.

Par ailleurs, des inconvénients similaires seraient obtenus en découpant un résonateur dans un wafer orienté selon la direction cristalline <110> d'un cristal de silicium. Dans ce cas, la valeur moyenne du module d'Young serait de 165 GPa. La coupe {110}, et les coupes équivalentes {101} et {011}, sont illustrées sur la figure 11B dans le cas d'un réseau cubique.

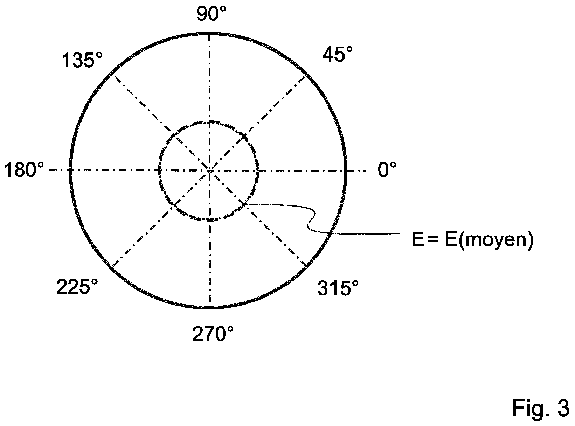

Afin de palier au moins partiellement à ces problèmes, EP2215531 suggère un spiral en silicium recouvert d'une couche de compensation thermique mais dont l'âme est obtenue à partir d'un wafer coupé dans le plan {111}, illustrée sur la figure 11C dans le cas d'un réseau cubique. La figure 3 montre que le module d'Young E est quasiment isotrope dans ce plan; sa valeur moyenne E(moyen) est d'environ 169 GPa. Ainsi un résonateur avec symétrie radiale qui oscille en breathing mode, comme par exemple un spiral, fabriqué dans un wafer coupé dans le plan {111} aura un développement plus concentrique qu'un résonateur du même type fabriqué dans un wafer de coupé dans le plan {001} ou {110}. Le procédé de mise en forme du silicium d'orientation <111> est cependant plus délicat que celui utilisé sur wafers d'orientations <001>}

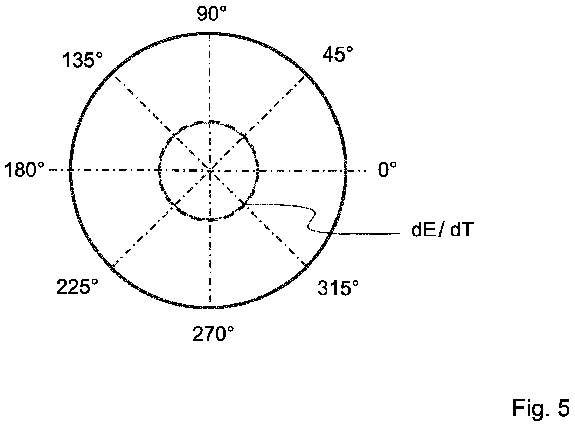

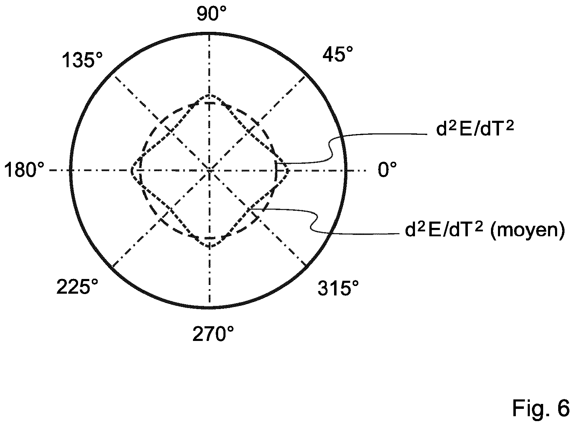

L'anisotropie du cristal de silicium influence dans une moindre mesure la sensibilité à la température du module d'Young. Le premier coefficient thermique, soit la dérivée $dE/dT$ du module d'Young par rapport à la température, est certes isotrope quel que soit le plan cristallin de la coupe {110}, {111} ou {001} (Figure 5). La valeur du premier coefficient thermique pour les coupes selon les plans {110}, {111} est de -64.25 ppm/C et de -64.27 ppm/C pour le plan {001}. Toutefois, à partir du coefficient thermique du second ordre (Figure 6), soit la deuxième dérivée $d^2E/dT^2$ du module d'Young par rapport à la température, on constate une anisotropie de cette valeur par rapport aux différentes orientations cristallines pour les trois familles de plan du silicium. Une meilleure homogénéité planaire de coefficients thermoélastiques d'ordre supérieur à « 1 » est avantageuse notamment dans la maitrise de la thermocompensation de résonateurs à moyenne ou faible symétrie radiale ayant besoin d'être thermocompensés à partir du deuxième ordre.

La croissance d'une couche d'oxyde sur le spiral de EP2215531 est obtenue par un procédé d'oxydation humide. Des oxydations de spiraux par chauffage dans une chambre d'oxydation sèche ont aussi été suggérées. En tous les cas, la croissance de l'oxyde est un processus lent, qui conduit à un temps de cycle de fabrication important. Pour les dimensions typiques de spiraux pour montres mécaniques, il faut faire croitre en surface du silicium des couches de SiO2 relativement épaisses, entre 2 et 5 microns, afin de thermocompenser l'ensemble spiral-balancier. Il est connu qu'à partir d'une certaine épaisseur de SiO2 thermique (env. 3 μm) les propriétés physico-chimiques de ces couches se dégradent et leur croissance devient trop lente. A titre d'exemple, la croissance de 3 microns de SiO2 par voie thermique dure plus de 50 heures.

Le silicium est un matériau fragile avec des contraintes de rupture en flexion inférieures à 10 GPa et en fatigue de l'ordre de 2 à 3 GPa. La présence d'angles vifs dans les structures typiques d'un résonateur en silicium est à l'origine de fortes concentrations de contraintes, qui peuvent rapidement produire des déformations et accélérer la rupture. EP1904901 décrit les avantages d'une couche de SiO2 en surface d'un composant horloger réalisé dans une galette (ou wafer) de silicium monocristallin afin de renforcer sa résistance mécanique. Malgré cette protection, toute fissure ou défaut capable de se propager au-delà de la surface oxydée de ce composant finira par entrainer sa casse totale du fait qu'elle se propagera sans obstacle à travers la structure cristalline du composant.

Dans toutes les solutions décrites ci-dessus, la présence d'une couche d'oxyde relativement épaisse (environ 8% de l'épaisseur totale du spiral) résulte en un spiral avec un état de surface foncé et mat, souvent considéré inesthétique.

De plus la croissance d'une couche d'oxyde à la surface d'un spiral en silicium se déroule à haute température, typiquement à 1100°C. Les dimensions originales du composant en silicium se dilatent sous l'effet de la chaleur et proportionnellement au coefficient de dilation thermique $\alpha_{Si}$. La croissance de l'oxyde se déroule donc sur un composant aux dimensions dilatées. Le retour à température ambiante en fin de procédé se déroule sur un composant composite, formé d'un noyau silicium et de la couche d'oxyde périphérique nouvellement formée. Le coefficient de dilation thermique de l'oxyde de silicium étant $\alpha_{SiO2}$ différent de celui du silicium $\alpha_{Si}(\alpha_{Si}> \alpha_{SiO2})$, il s'ensuit une élongation résiduelle des dimensions et une mise sous contrainte du composant. Ceci est particulièrement vrai dans le cas du spiral en silicium où l'élongation de la longueur du spiral peut atteindre des valeurs de l'ordre de 0.2%, modifiant ainsi l'angle de pitonnage, et provoquant la déformation de la géométrie du spiral sous les effets de la contrainte.

CH699780 présente un résonateur mécanique de type spiral réalisé à partir d'un wafer de silicium monocristallin. Les variations en température du module d'Young du spiral sont compensées par deux couches métalliques amorphes ou des couches d'oxydes disposées à l'intérieur du barreau de silicium et dont le coefficient thermique du module d'Young est opposé à celui du silicium. Cette solution ne permet pas de compenser l'anisotropie du module d'Young dans le plan du spiral.

Bref résumé de l'invention

Un but de la présente invention est de proposer un résonateur mécanique, notamment pour l'organe régulateur d'un mouvement d'horlogerie mécanique, qui permette d'éviter les inconvénients ci-dessus, ou en tout cas d'offrir un meilleur compromis entre ces inconvénients.

En particulier, un but de la présente invention est de proposer un nouveau résonateur mécanique.

En particulier, un but de la présente invention est de proposer un résonateur mécanique thermocompensé.

Un autre but est de proposer un résonateur mécanique moins fragile que les résonateurs réalisés en silicium ou en silicium oxydé en surface.

Un autre but est de proposer un résonateur mécanique dont le développement est concentrique.

Un autre but est de proposer un résonateur mécanique dont la concentricité du développement est peu affectée par la température.

Un autre but est de proposer un résonateur mécanique plus rapide à produire.

Un but est aussi de pallier les inconvénients cités auparavant et donc de proposer un oscillateur mécanique en silicium monocristallin, simple à fabriquer, dont les caractéristiques mécaniques sont similaires dans toutes les directions d'un plan.

Un autre but est de proposer un résonateur mécanique aux dimensions plus précises et présentant moins de contraintes résiduelles.

Selon un aspect, ces buts sont atteints au moyen d'un résonateur mécanique, notamment pour l'organe régulateur d'un mouvement d'horlogerie mécanique, le résonateur comprenant:

(i) une première couche de silicium découpé selon un premier plan cristallin du silicium ;
(ii) une deuxième couche de silicium découpée selon un deuxième plan cristallin du silicium ; (iii) au moins une couche de séparation entre les première et deuxième couches de silicium ;

le réseau cristallin de la première couche étant décalé d'un angle différent de 0°, 45° ou 180° par rapport à celui de la deuxième couche et/ou
le premier plan cristallin étant différent et non équivalent au deuxième plan cristallin.

Une couche de silicium est dite découpée selon un plan cristallin donné du silicium si elle a été obtenue par gravage d'un wafer découpé selon ce plan.

Des réseaux cristallins sont décalés d'un angle $\alpha$ lorsque les directions cristallines correspondantes ou équivalentes sont décalées d'un angle $\alpha$.

Les « directions cristallines » (ou directions nodales) des couches correspondent aux directions des vecteurs [xyz] joignant les nœuds n du cristal. Le silicium ayant une structure cristalline à symétrie cubique, les quatre diagonales sont équivalentes, les trois faces du cube sont équivalentes, etc. Par exemple, les directions [100], [1⁻00], [010], [01⁻0], [001], [001] et [001⁻] sont équivalentes entre elles et désignées par une famille de directions <100> (l'opérateur ⁻ désignant l'opposition).

Des plans sont dits équivalents s'ils peuvent être obtenus par permutations et/ou oppositions des indices. Le plan (xyz) est perpendiculaire à la direction [xyz]. Par exemple, les plans (100), (1⁻00), (010), (01⁻0), (001), (001) et (001⁻), sont équivalents et forme une famille de plans désignée par {100} (l'opérateur ⁻ désignant l'opposition).

La robustesse mécanique est renforcée du fait que le résonateur n'est pas constitué d'une structure monocristalline et monolithique mais de plusieurs couches monocristallines de réseaux cristallins séparées entre elles par une ou plusieurs couches de séparation. Ainsi, une fissure générée dans une couche de silicium cristallin peut être arrêtée par la couche de séparation, et éviter de se propager à l'autre couche cristalline.

Selon la première alternative revendiquée dans laquelle les réseaux cristallins des deux couches sont décalés angulairement, la robustesse mécanique est renforcée. Ainsi, une fissure générée dans une couche de silicium cristallin et qui aurait traversé la ou les couches de séparation a moins de risque de se propager dans l'autre couche de silicium cristallin, en raison des déphasages entre les plans de fissuration.

Selon la deuxième alternative, la robustesse mécanique est aussi renforcée grâce au gravage des différentes couches de silicium du résonateur dans des plans cristallins différents et non équivalents.

Par exemple, selon cette deuxième alternative, la première couche de silicium peut être gravée dans un wafer découpé selon le plan {001} et la deuxième couche de silicium dans un wafer découpé selon le plan {011} ou selon le plan {111}. Alternativement, la première couche de silicium peut être gravée dans un wafer découpé selon le plan {011} et la deuxième couche de silicium dans un wafer gravé selon le plan {111}. Selon ces modes de réalisation, les orientations cristallines sont par essence différentes et il existe intrinsèquement un décalage angulaire des réseaux respectifs qui favorise la robustesse de la structure.

Au moins une couche de séparation peut être constituée d'un matériau amorphe. Un matériau amorphe réduit encore le risque de propagation de fissures.

En choisissant, par exemple, une couche de séparation isotrope dans le plan, celle-ci présente un module d'Young également isotrope. Cette couche de séparation compense donc de manière homogène les variations de raideur subies par le résonateur, et n'ajoute pas d'anisotropie indésirable.

Au moins une couche de séparation présente de préférence un premier coefficient thermique du module d'Young isotrope dans le plan de la couche.

Au moins une couche de séparation présente de préférence un deuxième coefficient thermique du module d'Young isotrope dans le plan de la couche.

Dans un autre mode de réalisation, au moins une couche de séparation présente un module d'Young, ou un deuxième coefficient thermique du module d'Young, anisotrope dans son plan. La couche de séparation est alors de préférence orientée par rapport aux couches de silicium de manière à ce qu'elle compense l'anisotropie résiduelle du module d'Young, et/ou l'anisotropie résiduelle du deuxième coefficient thermique du module d'Young.

Au moins une couche de séparation peut être constituée d'un matériau présentant un coefficient thermique du module d'Young de signe opposé à celui du silicium. Ainsi la thermocompensation du résonateur mécanique ne se fait pas, ou pas uniquement, par l'intermédiaire d'une couche de SiO2 extérieure mais également par l'intermédiaire d'au moins une couche de séparation enterrée.

Au moins une couche de séparation peut être constituée de SiO2. La présence d'une couche d'oxyde enterrée ab initio, avant la réalisation du composant et la formation de l'oxyde périphérique, limite de facto l'élongation du noyau en silicium en phase de montée en température d'oxydation, et par voie de conséquence la dilation résiduelle et le développement de contrainte au retour à la température ambiante. Cette solution est particulièrement avantageuse dans le cas de composants dont la dilatation thermique serait catastrophique, par exemple dans le cas du flambage de poutres encastrées aux deux extrémités. L'oxydation de dispositifs faisant appel à ce type d'éléments, comme les guidages flexibles, est très limitée.

Le résonateur peut comprendre plus de deux couches de silicium séparées les unes des autres.

Le résonateur peut comprendre plusieurs couches de séparation entre deux couches de silicium.

Le résonateur peut comporter une couche externe constituée d'un matériau présentant un coefficient thermique du module d'Young de signe opposé à celui du silicium. L'utilisation de la couche de séparation effectuant une compensation thermique entre les première et deuxième couches de silicium permet de limiter l'épaisseur de cette couche externe. L'épaisseur de cette couche externe est supérieure à l'épaisseur de l'oxyde de silicium natif résultant de l'oxydation naturelle du silicium à température ambiante.

Le résonateur peut être un résonateur mécanique à symétrie radiale.

Le résonateur peut être un résonateur mécanique de type spiral.

Selon les modes de réalisation de l'invention, au moins certains des avantages suivants peuvent être obtenus :

**Homogénéité planaire des propriétés élastiques et thermoélastiques :**

- A) Maitrise des oscillations et oscillations concentriques dans le cas de résonateurs à symétrie radiale.
- B) Meilleure corrélation entre résultats de simulation lors du design du résonateur et résultats expérimentaux.
- C) Libre orientation de secteurs asymétriques du résonateur par rapport au plan du wafer.
- D) Meilleur rendu esthétique des résonateurs en battement.

**Couche enterrée**

- A) Moins d'oxyde nécessaire pour la thermocompensation en surface des résonateurs.
- B) Temps de cycle de fabrication plus courts.
- C) Meilleure qualité de l'oxyde en surface (composition, structure et état de surface).
- D). Meilleur contrôle des contraintes résiduelles et limitation des défauts dimensionnels (élongation du ressort) lors de la mise en forme comportant la gravure DRIE et l'oxydation du composant à haute température

**Décalage de réseaux cristallins**

- A) Meilleure robustesse mécanique du système.
- B) Retarder la propagation de fissures et la casse prématurée du ressort.

L'invention a aussi pour objet un procédé de fabrication d'un résonateur mécanique.

Selon un mode de réalisation, le procédé de fabrication d'un résonateur mécanique comporte la déposition d'une couche de séparation sur un wafer de silicium, puis la gravure de plusieurs résonateurs mécanique dans ce wafer. La couche de séparation peut être par exemple une couche de compensation thermique, par exemple une couche de SiO2. La couche de compensation thermique est ainsi déposée en une seule opération sur tous les résonateurs produits à partir d'un wafer, ce qui réduit le temps de fabrication et le risque de briser les résonateurs lors de leurs manipulations après leur gravure.

Au sens de l'invention, on entend par « déposer une couche de matériau », les procédés consistants à ajouter de la matière par dépôt, ajouter de la matière par croissance et transformation de la matière existante ou le report d'une couche annexe par scellement de la couche annexe.

Le procédé peut comporter la déposition d'une deuxième couche de silicium sur la couche de séparation, les résonateurs mécaniques étant gravés après cette déposition.

Le procédé peut comporter la déposition d'une deuxième couche de silicium sur la couche de séparation après ladite étape de gravure des résonateurs mécaniques. La première couche de silicium peut alors être utilisée comme masque pour la gravure de la deuxième couche de silicium.

Le procédé peut comporter le scellement de plusieurs wafers de silicium dont l'un au moins est recouvert d'une couche de séparation, par exemple d'une couche de SiO2, puis la gravure d'une pluralité de résonateurs dans cet empilement.

Brève description des figures

Des exemples de mise en œuvre de l'invention sont indiqués dans la description illustrée par les figures annexées dans lesquelles :

- La figure 1 illustre à titre d'exemple un résonateur mécanique, ici un spiral.

- La figure 2 indique la valeur E du module d'Young selon les différentes directions d'un plan {001}, ainsi que sa valeur moyenne E(moyen).

- La figure 3 indique la valeur E du module d'Young selon les différentes direction du plan {111}, ainsi que sa valeur moyenne E(moyen).

- La figure 4 illustre la variation de raideur de la courbe terminale d'un spiral selon différentes orientations du spiral dans le plan {001}.

- La figure 5 illustre la variation dE/dT du premier coefficient thermique du module d'Young pour un wafer coupé dans les plans {001}, {011} ou {111}. Ce premier coefficient est anisotrope et sa valeur moyenne dE/dT(moyen) ne diffère donc pas de la valeur absolue pour chaque direction.

- La figure 6 illustre la variation $d^2E/dT^2$ du deuxième coefficient thermique du module d'Young pour un wafer coupé dans les plans {001}, {011} ou {111}, ainsi que sa valeur moyenne.

- La figure 7 illustre une section transversale d'une portion d'un résonateur, par exemple la section d'une spire d'un spiral, gravé ici dans deux couches de silicium monocristallin coupées dans des plans similaires mais dont les réseaux cristallins sont décalés de 30°

- La figure 8 illustre une section transversale d'une portion d'un résonateur, par exemple la section d'une spire d'un spiral, gravé ici dans trois couches de silicium découpées selon des plans différents ({001} ou {111}) et séparées les unes des autres par des couches de SiO2 enterrées. Dans cet exemple, il n'y a pas de décalage angulaire de la direction entre les deux couches découpées selon le plan {001}.

- La figure 9 illustre schématiquement deux wafers de silicium découpés dans le plan {001} dont les réseaux cristallins sont décalés de 30°, ainsi que le module d'Young planaire $E_A$, $E_B$ des deux wafers.

- La figure 10 illustre schématiquement, en 2D, trois wafers de silicium coupés dans le plan {001} dont les réseaux cristallins sont décalés de 30°, ainsi que le module d'Young planaire $E_A$, $E_B$, Ec des trois wafers.

- La figure 11 illustre schématiquement les directions cristallines dans un cristal cubique. Les directions cristallines sont définies de la même façon dans un cristal cubique à face centrée, tel que le silicium.

- La figure 12 est une représentation schématique du procédé de réalisation d'un résonateur mécanique selon un premier mode de réalisation ;

- La figure 13 est une représentation schématique du procédé de réalisation d'un résonateur mécanique selon un deuxième mode de réalisation ;

- La figure 14 est une représentation schématique du procédé de réalisation d'un résonateur mécanique selon un troisième mode de réalisation ;

- La figure 15 est une représentation schématique du procédé de réalisation d'un résonateur mécanique selon un quatrième mode de réalisation ;

- La figure 16 est une représentation schématique du procédé de réalisation d'un résonateur mécanique selon un cinquième mode de réalisation ; et

- La figure 17 est une représentation schématique du procédé de réalisation d'un résonateur mécanique selon un sixième mode de réalisation.

Exemple(s) de mode de réalisation de l'invention

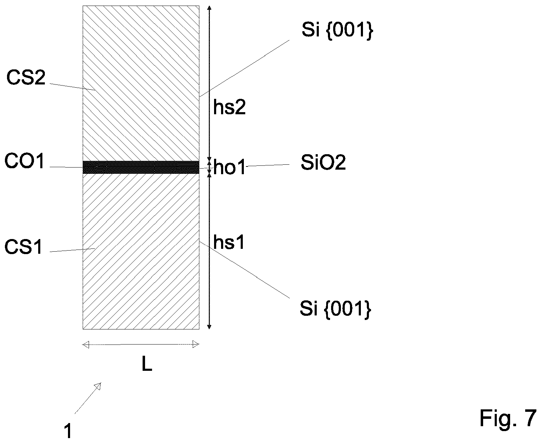

La figure 7 illustre une coupe transversale d'une portion de résonateur mécanique, par exemple sous la forme d'un segment droit, d'un hélicoïde ou d'une spire de spiral. Cette figure montre un empilement de trois couches : une première couche de silicium Cs1 monocristallin directement au contact d'une couche de séparation Co1 directement au contact d'une deuxième couche de silicium Cs2 monocristallin. La couche de séparation Co1 peut être une couche de compensation thermique, par exemple une couche de matériau amorphe, par exemple une couche de SiO2.

La première couche de silicium Cs1 s'étend sur une hauteur hs1 et sur toute la largeur L du résonateur 1. La deuxième couche de silicium Cs2 s'étend sur une hauteur hs2 sensiblement égale à la hauteur hs1 et sur toute la largeur L. La couche de séparation Co1 s'étend sur une hauteur ho1 très inférieure aux deux hauteurs hs1, hs2 et sur toute la largeur L.

Il est aussi possible de prévoir plusieurs couches de séparation entre les deux couches de silicium Cs1, Cs2.

Dans cet exemple, la première couche de silicium Cs1 et la deuxième couche de silicium proviennent de wafers découpés selon le même plan cristallin, de préférence le plan {001}, ou le plan {011}. Il est aussi possible de prévoir un empilement de couches de silicium obtenues à partir de wafers découpés selon des plans cristallins différents; par exemple une couche découpée dans un wafer {001} et une autre couche découpée dans un wafer {011}.

Le réseau cristallin Ds1 de la première couche de silicium Cs1 est décalée d'un angle $\alpha$ par rapport au réseau cristallin Ds2 de la deuxième couche de silicium Cs2. Les directions Ds1, Ds2 sont définies à partir de n'importe quel vecteur cristallin correspondants dans les couches Cs1, Cs2.

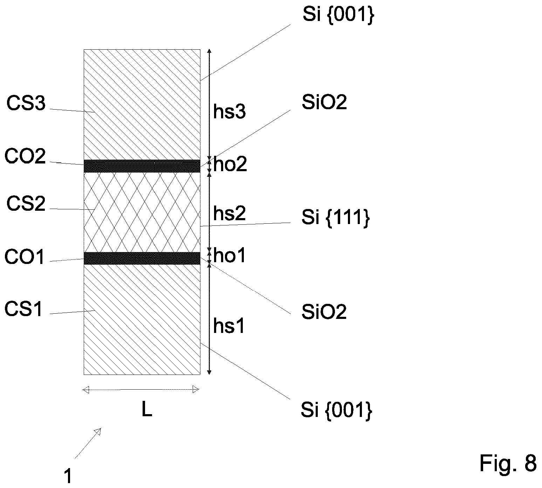

Les hachures des figures 7 et 8 permettent de visualiser de manière schématique les décalages entre les directions Ds1 et Ds2. Cependant, les décalages entre les directions Ds1 et Ds2 sont effectuées dans le plan des couches de silicium.

La couche de séparation Co1 est avantageusement constituée d'un matériau présentant un coefficient thermique du module d'Young de signe opposé à celui du silicium de sorte que la variation de la raideur des couches de silicium Cs1, Cs2 en fonction de la température soit, au moins partiellement, compensée par la couche de séparation Co1. De préférence, la couche de séparation Co1 est formée d'oxyde de silicium. Le coefficient thermique du module d'Young pour le silicium est de -64.10$^{-6}$K$^{-1}$ et le coefficient thermique du module d'Young pour l'oxyde de silicium est de 187,5.10$^{-6}$K$^{-1}$ à une température ambiante, environ 20°C. Ainsi, pour compenser, au moins partiellement, la variation de la raideur des couches de silicium Cs1, Cs2 en fonction de la température, le rapport volumique entre la couche de séparation et de compensation thermique Co1 et les couches de silicium Cs1, Cs2 est avantageusement d'au moins 5%, de préférence au moins 10%, par exemple plus de 20%, à une température ambiante de 20°C. Sur la figure 7, la surface de la section ho1.L est donc au moins égale à 20 % de la surface des sections L.hs1 et L.hs2. Dans un exemple, l'épaisseur de la couche de séparation Co1 est comprise entre 1 et 4 microns, par exemple 2 microns.

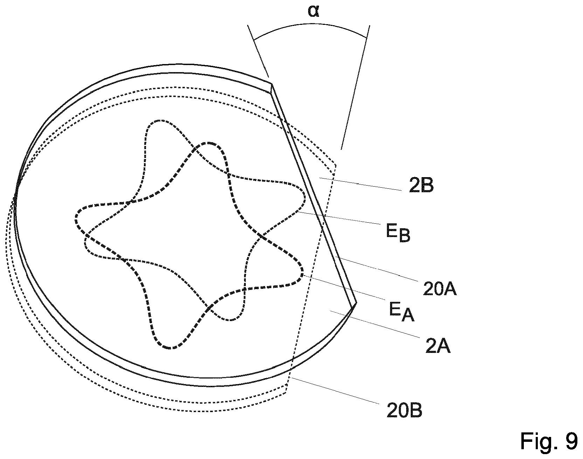

La figure 9 illustre un empilement de deux wafers coupés dans le plan {001}, le réseau cristallin du wafer supérieur 2B étant décalé angulairement d'un angle $\alpha$ dans cet exemple par rapport au réseau cristallin du wafer inférieur 2A. La figure montre aussi la valeur du module d'Young $E_A$ respectivement $E_B$, selon la direction, pour chacun des deux wafers 2A respectivement 2B. Comme on le voit schématiquement sur cette figure, les maximas et les minimas du module d'Young ne correspond pas sur les deux wafers, en sorte que la valeur du module d'Young des deux wafers superposés (ou d'un composant gravé dans ces deux wafers superposés) est moins dépendante de la direction. Dans l'exemple illustré, le déphasage $\alpha$ est de 30°. D'autres valeurs de déphasage sont cependant possibles, par exemple n'importe quelle valeur différente de N X 90°, N étant un nombre entier quelconque. Le déphasage est également différent de 45°.

La plupart des wafers de silicium présentent un méplat, représenté par les références 20A respectivement 20B sur la figure 9. Le déphasage des wafers superposés peut être obtenu en contrôlant l'angle entre ces deux méplats, puis en scellant les deux wafers l'un à l'autre avant la gravure des résonateurs.

La figure 8 illustre une variante de l'invention dans laquelle le résonateur 1, illustré en coupe transversale, comporte trois couches de silicium Cs1, Cs2, Cs3 entrecoupées par deux couches de compensation thermique Co1, Co2. La direction cristalline Ds1 de la première couche de silicium Cs1 est la même que la direction cristalline Ds3 de la troisième couche de silicium Cs3. La deuxième couche de silicium Cs2 disposée entre la première et la troisième couche de silicium Cs1, Cs3 comporte un réseau cristallin dont la direction Ds2 est décalée d'un angle de préférence différent de 0°, 45° et 180° par rapport aux directions cristallines correspondantes des couches Ds1, Ds3.

Dans cet exemple, la première couche de silicium Cs1 et la troisième couche de silicium sont gravées dans des wafers découpés selon le même plan cristallin, de préférence le plan {001}, ou de la famille {011}. La deuxième couche de silicium est quant à elle gravée dans un wafer selon le plan cristallin {111} qui possède des propriétés thermoélastiques plus homogènes dans toutes les directions du plan. La compensation des variations du module d'Young selon la direction se fait donc avant tout entre les couches Cs1 et Cs3.

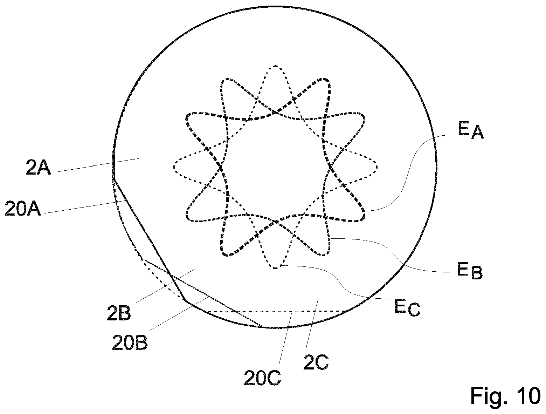

Les couches Cs1 à Cs3 peuvent cependant correspondre à n'importe quel plan de coupe ou combinaison de plans de coupe des familles de plan {110}, {111} et {001}. Dans un autre mode de réalisation, les couches correspondent à une combinaison des plans de coupe des familles {110} et {001}. Dans un mode de réalisation préférentiel l'ensemble des couches correspondent au plan des familles {001}, décalées angulairement les unes des autres de manière à homogénéiser les propriétés élastiques et thermoélastiques. Dans un exemple préférentiel, cet angle de décalage entre les directions cristallines correspondantes peut être de 30 degrés (Figure 10).

La hauteur hs2 de la deuxième couche de silicium Cs2 peut être égale ou différente à la somme des hauteurs hs1 et hs3 des deux autres couches de silicium Cs1, Cs3. Afin de compenser, au moins partiellement, la dérive en température, la somme des hauteurs des couches de séparation Co1 et Co2 est avantageusement d'au moins 5%, de préférence au moins 10%, par exemple plus de 20%, de la somme des hauteurs des couches de silicium Cs1, Cs2, Cs3.

Dans tous les modes de réalisation, l'épaisseur des couches de séparation Co1, Co2 peut être avantageusement comprise entre 1 et 4 microns, par exemple 2 microns. Différentes couches de séparation peuvent être réalisées dans le même matériau, ou dans des matériaux différents. L'épaisseur de différentes couches de séparation peut être identique ou variable. Deux couches de silicium peuvent être séparées par différentes couches de séparation en différents matériaux.

Dans tous les modes de réalisation, au moins une couche de séparation présente de préférence un module d'Young isotrope et/ou un coefficient thermique du module d'Young isotrope dans son plan. La ou les couches de séparation n'influencent donc pas l'isotropie du module d'Young du résonateur, dans les plans parallèles aux couches. A cet effet, les couches de séparation peuvent être réalisées dans un matériau amorphe, par exemple en SiO2 amorphe.

Alternativement, dans un mode de réalisation, au moins une couche de séparation peut présenter un module d'Young et/ou un coefficient thermique du module d'Young module anisotrope dans son plan, agencé pour compenser au moins partiellement l'anisotropie résiduelle du module d'Young des couches de silicium empilées, et/ou l'anisotropie résiduelle du deuxième coefficient thermique du module d'Young.

Dans tous les modes de réalisation, le résonateur 1 peut comporter une couche externe non illustrée et constituée d'un matériau présentant un coefficient thermique du module d'Young de signe opposé à celui du silicium. L'utilisation d'une couche de séparation effectuant une compensation thermique entre les première et deuxième couches de silicium permet de limiter l'épaisseur de cette couche externe, et donc le temps de fabrication de chaque résonateur. L'épaisseur de cette couche externe peut être supérieure à l'épaisseur de l'oxyde de silicium natif résultant de l'oxydation naturelle du silicium à température ambiante. La somme des surfaces des couches de séparation et de la couche externe est déterminée de manière à compenser le plus précisément possible la variation du module d'Young selon la température. La couche externe peut être disposée sur toutes les faces du résonateur, ou seulement sur les faces supérieures et inférieures. Elle peut être obtenue par oxydation du silicium dans une chambre d'oxydation.

La figure 10 illustre un empilement de trois wafers de plan de coupe {001} 2A, 2B et 2C. La direction cristalline des trois wafers est décalée l'une par rapport à l'autre. Dans l'exemple préférentiel illustré, le décalage est de 30°. D'autres valeurs de décalage sont possibles. La figure montre aussi la valeur du module d'Young $E_A$ respectivement $E_B$ et Ec, selon la direction, pour chacun des trois wafers 2A, 2B et respectivement 2C. Comme on le voit schématiquement sur cette figure, la valeur du module d'Young de l'empilement est homogénéisée selon la direction.

Plusieurs résonateurs multiâmes 1 sont de préférence gravés dans un empilement de wafers scellés les uns aux autres avant la gravure, au moins une couche de séparation étant réalisée sur au moins un des wafers avant leur gravure. Les différents wafers sont donc orientés les uns par rapport aux autres avant la gravure des résonateurs.

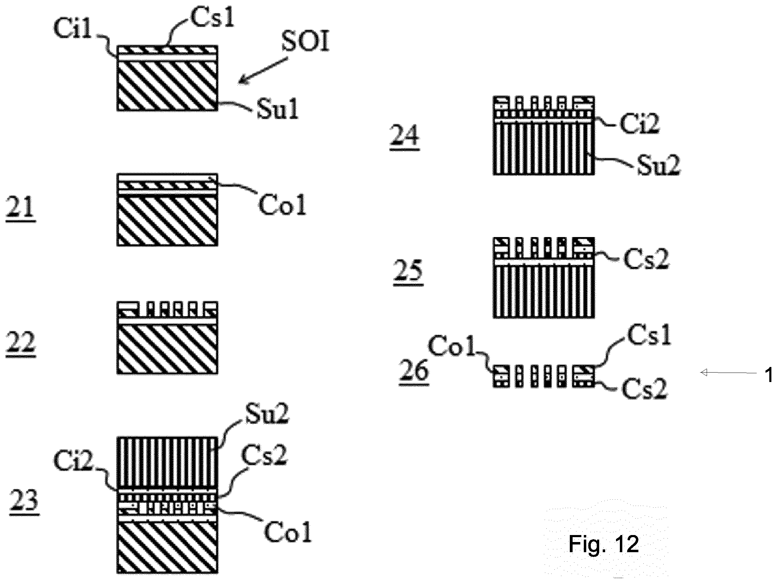

Les figures 12 à 17 illustrent des procédés de réalisation d'un résonateur 1 selon la figure 1. Le procédé de la figure 12 utilise deux wafers de silicium du type silicium sur isolant SOI. Chaque wafer du type silicium sur isolant SOI comporte un substrat Su1, Su2 surmonté d'une couche d'isolant Ci1, Ci2 puis d'une couche de de silicium monocristallin Cs1, Cs2. Le substrat Su1, Su2, peut être réalisé en silicium. Dans une première étape 21, une couche de séparation Co1, par exemple une couche de SiO2 amorphe, est déposée sur la couche de silicium Cs1 du premier wafer. Dans une deuxième étape 22, un ou plusieurs motifs de résonateurs mécaniques sont gravés sur la couche de séparation Co1 et sur la couche de silicium Cs1. Dans une troisième étape 23, la couche de silicium Cs2 du deuxième wafer est scellée sur la couche de séparation Co1. Le deuxième wafer est décalé d'un angle α par rapport au premier wafer avant cette étape 23 de scellement de sorte que les directions Ds1, Ds2 des réseaux cristallins soient également décalées d'un angle α. Dans une étape 24, l'assemblage est retourné et le substrat Su1 ainsi que la couche d'isolant Ci1 du premier wafer sont retirés. Dans une étape 25, la couche de silicium Cs2 du deuxième wafer est gravée au motif de résonateurs mécaniques en utilisant la première couche de silicium Cs1 comme masque de gravure. La gravure peut être effectuée par une technique de gravure ionique réactive profonde (également connu sous l'acronyme DRIE pour « Deep Reactive Ion Etching »). Le substrat Su2 et la couche d'isolant Ci2 du deuxième wafer de silicium sont ensuite retirés dans une étape 26 pour libérer le ou les résonateurs mécaniques 1.

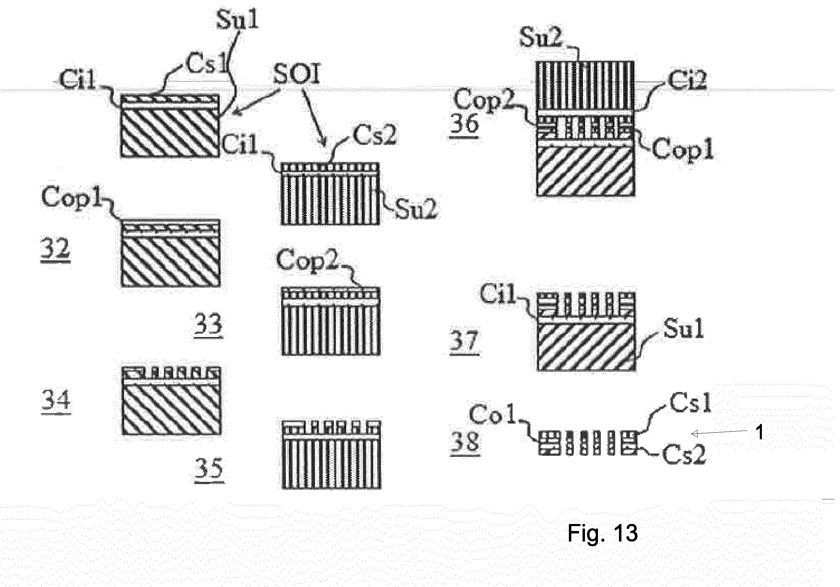

La figure 13 illustre un procédé de réalisation utilisant également deux wafers SOI. Dans les étapes 32 et 33, deux parties Cop1, Cop2 de la couche de séparation Co1 sont déposées respectivement sur chaque couche de silicium Cs1, Cs2 des deux wafers SOI. Dans les étapes 34, 35, les motifs du ou des résonateurs sont ensuite gravés sur les deux parties Cop1 et Cop2 de la couche de séparation Co1 ainsi que sur les deux couches de silicium Cs1, Cs2 des deux wafers. Dans une étape 36, les deux parties Cop1, Cop2 sont ensuite scellées avec un décalage α entre les wafers de sorte à former la couche complète de séparation Co1. Les étapes 37, 38 consistent à supprimer les deux substrats Su1, Su2 ainsi que les deux couches d'isolant Ci1, Ci2 afin de libérer le ou les résonateurs mécaniques.

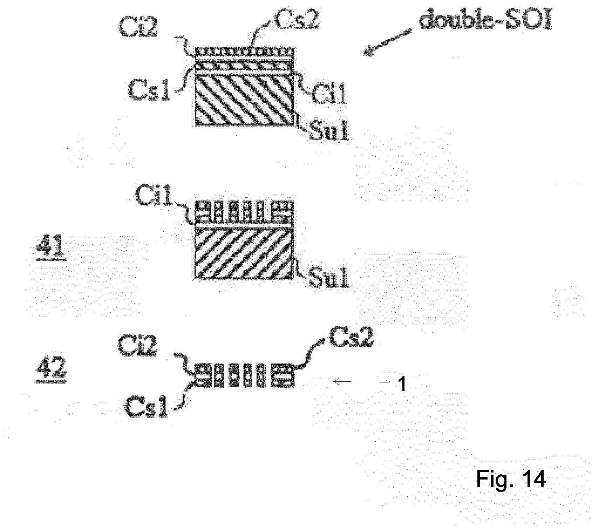

La figure 14 illustre un procédé de réalisation utilisant un seul wafer du type double-SOI. Un wafer du type double-SOI est constitué d'un substrat Su1 surmonté d'une première couche d'isolant Ci1, d'une première couche de silicium monocristallin Cs1, d'une deuxième couche d'isolant Ci2 puis d'une deuxième couche de silicium monocristallin Cs2. La deuxième couche d'isolant Ci2 réalise ainsi la fonction de la couche séparation et de compensation thermique Co1 du résonateur 1. La première couche de silicium Cs1 et la deuxième couche de silicium Cs2 comportent des réseaux cristallins dont les directions sont décalées d'un angle α. Une première étape 41 consiste à graver le motif de résonateur mécanique dans la deuxième couche de silicium Cs2, la deuxième couche d'isolant Ci2 et la première couche de silicium Cs1. Une seconde étape 42 consiste à retirer le substrat Su1 et la première couche d'isolant Ci1 pour libérer le résonateur mécanique.

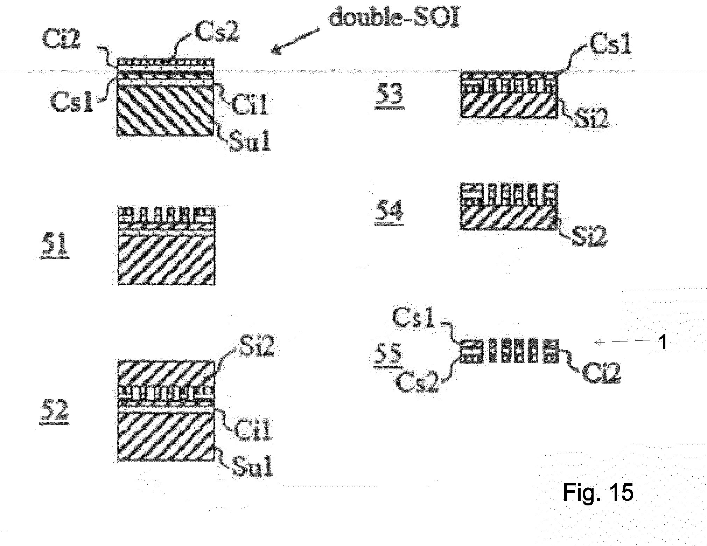

La figure 15 illustre une variante du procédé de la figure 14 utilisant un wafer du type double-SOI. Une première étape 51 consiste à graver le motif de résonateurs mécaniques dans la deuxième couche de silicium Cs2 et la deuxième couche d'isolant Ci2. Dans une deuxième étape 52, un wafer de silicium Si2 est scellé sur la deuxième couche de silicium Cs2. Ce wafer de silicium Si2 est une couche sacrificielle qui sert uniquement de support à la structure et sera supprimée dans une étape ultérieure. Dans une étape 53, l'assemblage est retourné et le substrat Su1 ainsi que la première couche d'isolant Ci1 du premier wafer sont retirés. Le motif de résonateur mécanique est gravé sur la première couche de silicium Cs1 dans une étape 54 et, dans une étape 55, le wafer de silicium Si2 est retiré pour libérer le ou les résonateurs mécaniques 1. Cette variante du procédé de la figure 14 peut être mise en œuvre lorsque les résonateurs 1 sont trop épais et que l'étape 41 de gravure ne permet pas de graver correctement la première couche de silicium Cs1.

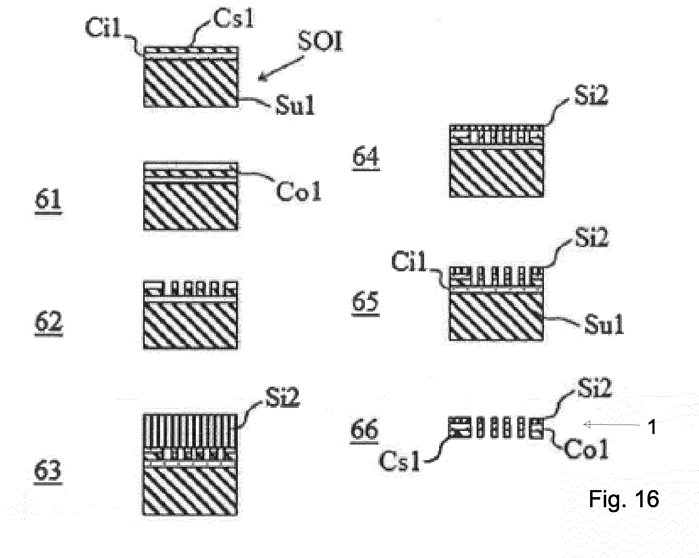

La figure 16 illustre un procédé de réalisation utilisant un wafer du type SOI et un wafer de silicium Si2. Dans une première étape 61, une couche de séparation Co1 est déposée sur la couche de silicium Cs1 du premier wafer de type SOI. Dans une deuxième étape 62, un motif de résonateurs mécaniques est gravé sur la couche de séparation Co1 et sur la couche de silicium Cs1. Le wafer de silicium Si2 est ensuite scellé avec un décalage α sur la couche de séparation Co1 dans une étape 63. L'étape 64 consiste à amincir le wafer de silicium Si2 jusqu'à atteindre la hauteur hs2 souhaitée pour la deuxième couche de silicium Cs2 du résonateur 1. Dans une étape 65, le motif de résonateur mécanique 1 est gravé sur la deuxième couche de silicium Cs2 formé par le wafer de silicium Si2 et, dans une étape 66, le substrat Su1 et la couche d'isolant Ci1 sont retirés pour libérer le ou les résonateurs mécaniques.

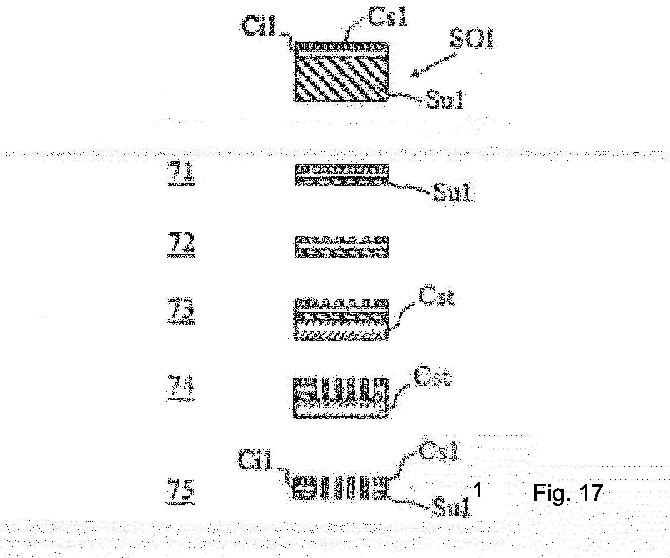

La figure 17 illustre un procédé de réalisation utilisant un seul wafer du type SOI dans laquelle le substrat Su1 est réalisé en silicium et forme la deuxième couche de silicium Cs2. La couche de séparation Co1 est formée par une couche d'isolant Ci1 préférentiellement réalisée en oxyde de silicium. Une première étape 71 consiste à amincir le substrat Su1 jusqu'à atteindre la hauteur hs2 souhaitée pour la deuxième couche de silicium Cs2. Dans une étape 72, le motif d'un ou plusieurs résonateurs mécanique est gravé sur la couche de silicium Cs1. Une couche de structuration Cst est ensuite déposée sur le substrat aminci Su1 dans une étape 73 afin de rigidifier la structure puis le motif de résonateurs mécaniques est gravé dans les couches d'isolant Ci1 et de substrat Su1 dans une étape 74. Dans une étape 75, la couche de structuration Cst est retirée pour libérer les résonateurs mécaniques 1.

En variante, une couche externe de compensation thermique peut être réalisée dans une chambre d'oxydation du silicium formant ainsi une couche d'oxyde de silicium autour du résonateur 1.

La réalisation d'une deuxième couche de séparation Co2 et d'une troisième couche de silicium Cs3 peut être réalisée, par exemple, par le scellement d'un troisième wafer de type silicium sur isolant et par des étapes supplémentaires de gravure correspondantes.

## Revendications

1. Un résonateur mécanique, notamment pour l'organe régulateur d'un mouvement d'horlogerie mécanique, le résonateur comprenant:

   (i) une première couche de silicium (Cs1) découpé dans un premier plan cristallin du silicium ;
   (ii) une deuxième couche de silicium (Cs2) découpé dans un deuxième plan cristallin du silicium ;
   (iii) au moins une couche de séparation entre les première et deuxième couches de silicium (Cs1, Cs2) ;

   **caractérisé en ce que**
   le réseau cristallin de la première couche est décalé d'un angle différent de 0°, 45° ou 180° par rapport à celui de la deuxième couche et/ou **en ce que** le premier plan cristallin est différent et non équivalent au deuxième plan cristallin.

2. Résonateur selon la revendication 1, au moins une dite couche de séparation étant constituée d'un matériau amorphe.

3. Résonateur selon l'une des revendications 1 ou 2, au moins une dite couche de séparation présentant un module d'Young isotrope dans son plan.

4. Résonateur selon l'une des revendications 1 à 3, au moins une dite couche de séparation présentant un coefficient thermique du module d'Young isotrope dans son plan.

5. Résonateur selon la revendication 1, au moins une dite couche de séparation présentant un module d'Young et/ou un coefficient thermique du module d'Young module anisotrope dans son plan, agencé pour compenser au moins partiellement l'anisotropie résiduelle du module d'Young, et/ou l'anisotropie résiduelle du deuxième coefficient thermique du module d'Young.

6. Résonateur selon l'une des revendications 1 à 5, au moins une dite couche de séparation étant constituée d'un matériau présentant un coefficient thermique du module d'Young de signe opposé à celui du silicium.

7. Résonateur selon l'une des revendications 1 à 4, au moins une dite couche de séparation étant constituée de SiO2.

8. Résonateur selon l'une des revendications 1 à 7, l'épaisseur d'au moins une dite couche de séparation étant comprise entre 1 et 4 microns.

9. Résonateur selon l'une des revendications 1 à 8, le deuxième plan cristallin étant différent et non équivalent au premier plan cristallin.

10. Résonateur selon l'une des revendications 1 à 8, le deuxième plan cristallin étant identique ou équivalent au premier plan cristallin, la direction cristalline de la première couche étant décalée par l'angle (a) différent de 0°, 45° ou 180° de toute direction cristalline équivalente de la deuxième couche, les orientations des réseaux cristallins desdites première et deuxième couches de silicium étant ainsi différentes.

11. Résonateur selon l'une des revendications 1 à 10, comprenant plus de deux couches de silicium séparées les unes des autres par au moins une couche de séparation.

12. Résonateur selon l'une des revendications 1 à 11, comprenant plusieurs dites couches de séparation entre les couches de silicium.

13. Résonateur selon l'une des revendications 1 à 12, comprenant une couche externe constituée d'un matériau présentant un coefficient thermique du module d'Young de signe opposé à celui du silicium.

14. Procédé de fabrication d'un résonateur mécanique selon l'une des revendications 1 à 13, comportant la déposition d'une couche de séparation sur un wafer de silicium, puis la gravure de plusieurs résonateurs mécanique dans ce wafer.

15. Le procédé de la revendication 14, comportant la déposition d'une deuxième couche de silicium sur la couche de séparation, les résonateurs mécaniques étant découpés après cette déposition.

16. Le procédé de la revendication 14, comportant la déposition d'une deuxième couche de silicium sur la couche de séparation après ladite étape de gravure des résonateurs mécaniques.

## Patentansprüche

1. Mechanischer Resonator, insbesondere für das Regulierorgan eines mechanischen Uhrwerks, wobei der Resonator folgendes umfasst:

   (i) eine erste Schicht aus Silizium (CsI), die aus einer ersten Kristallebene des Siliziums geschnitten wurde;
   (ii) eine zweite Schicht aus Silizium (Cs2), die aus einer zweiten Kristallebene des Siliziums geschnitten wurde;
   (iii) mindestens eine Trennschicht zwischen der ersten und zweiten Siliziumschicht (Cs1, Cs2);

**dadurch gekennzeichnet, dass**
das Kristallgitter der ersten Schicht um einen Winkel gegenüber dem der zweiten Schicht verschoben ist, der weder 0°, noch 45° noch 180° beträgt und/oder dadurch, dass die erste Kristallebene anders ausgebildet ist als die zweite Kristallebene und mit ihr nicht übereinstimmt.

2. Resonator nach Anspruch 1, wobei mindestens eine der genannten Trennschichten aus einem amorphen Material besteht.

3. Resonator nach einem der Ansprüche 1 oder 2, wobei mindestens eine der genannten Trennschichten in ihrer Ebene ein isotropes Young-Modul aufweist.

4. Resonator nach einem der Ansprüche 1 bis 3, wobei mindestens eine der genannten Trennschichten einen Wärmekoeffizienten des isotropen Young-moduls in ihrer Ebene aufweist.

5. Resonator nach Anspruch 1, wobei mindestens eine der genannten Trennschichten ein anisotropes Young-Modul und/oder einen thermischen Koeffizienten des anisotropen Young-Moduls in seiner Ebene aufweist, so angeordnet, um zumindest teilweise die Restanisotropie des Young-Moduls und/oder die Restanisotropie des zweiten thermischen Koeffizienten des Young-Moduls zu kompensieren.

6. Resonator nach einem der Ansprüche 1 bis 5, wobei mindestens eine der genannten Trennschichten aus einem Material mit einem Wärmekoeffizienten des Young-Moduls mit entgegengesetztem Vorzeichen zu dem von Silizium besteht.

7. Resonator nach einem der Ansprüche 1 bis 4, wobei mindestens eine der genannten Trennschichten aus SiO2 besteht.

8. Ein Resonator nach einem der Ansprüche 1 bis 7, wobei die Dicke mindestens einer der genannten Trennschichten zwischen 1 und 4 Mikrometern beträgt.

9. Resonator nach einem der Ansprüche 1 bis 8, wobei die zweite Kristallebene zur ersten Kristallebene verschieden ist und mit ihr nicht gleichwertig ist.

10. Resonator nach einem der Ansprüche 1 bis 8, wobei die zweite Kristallebene mit der ersten Kristallebene identisch oder äquivalent ist, die Kristallrichtung der ersten Schicht um einen Winkel (a) gegenüber jeder äquivalenten Kristallrichtung der zweiten Schicht versetzt ist, der weder 0° noch 45° noch 90° beträgt, wodurch die Kristallgitterorientierungen der ersten und der zweiten Siliziumschicht unterschiedlich sind.

11. Resonator nach einem der Ansprüche 1 bis 10, umfassend mehr als zwei Siliziumschichten, die durch mindestens eine Trennschicht voneinander getrennt sind.

12. Resonator nach einem der Ansprüche 1 bis 11, umfassend eine Vielzahl der genannten Trennschichten zwischen den Siliziumschichten.

13. Resonator nach einem der Ansprüche 1 bis 12, umfassend eine äußere Schicht, die aus einem Material mit einem thermischen Koeffizienten des Young-Moduls mit entgegengesetztem Vorzeichen zu dem von Silizium besteht.

14. Verfahren zur Herstellung eines mechanischen Resonators nach einem der Ansprüche 1 bis 13, umfassend das Auftragen einer Trennschicht auf einem Siliziumwafer und das anschließende Ätzen einer Vielzahl von mechanischen Resonatoren in diesen Wafer.

15. Verfahren nach Anspruch 14, umfassend das Auftragen einer zweiten Siliziumschicht auf der Trennschicht, wobei die mechanischen Resonatoren nach diesem Auftragen ausgeschnitten werden.

16. Verfahren nach Anspruch 14, umfassend das Auftragen einer zweiten Siliziumschicht auf der Trennschicht nach dem genannten Ätzvorgang der mechanischen Resonatoren.

## Claims

1. A mechanical resonator, in particular for the regulator member for regulating a mechanical timepiece movement, the resonator comprising:

   (i) a first layer of silicon (Cs1) cut out from a first crystal plane of the silicon;
   (ii) a second layer of silicon (Cs2) cut out from a second crystal plane of the silicon; and
   (iii) at least one separation layer between the first and second layers of silicon (Cs1, Cs2);

   said mechanical resonator being **characterized in that**
   the crystal lattice of the first layer is offset by an angle different from 0°, 45° or 180° relative to the crystal lattice of the second layer, and/or **in that**
   the first crystal plane is different from and not equivalent to the second crystal plane.

2. A resonator according to claim 1, at least one said separation layer being made of an amorphous material.

**3.** A resonator according to claim 1 or claim 2, at least one said separation layer having a Young's modulus that is isotropic in its plane.

**4.** A resonator according to any one of claims 1 to 3, at least one said separation layer having a thermal coefficient of Young's modulus that is isotropic in its plane.

**5.** A resonator according to claim 1, at least one said separation layer having a Young's modulus and/or a thermal coefficient of Young's modulus that is/are anisotropic in its plane, which resonator is arranged to compensate at least partially for the residual anisotropy of the Young's modulus and/or for the residual anisotropy of the second thermal coefficient of Young's modulus.

**6.** A resonator according to any one of claims 1 to 5, at least one said separation layer being made of a material having a thermal coefficient of Young's modulus of opposite sign from the thermal coefficient of Young's modulus of silicon.

**7.** A resonator according to any one of claims 1 to 4, at least one said separation layer being made of SiO$_2$.

**8.** A resonator according to any one of claims 1 to 7, the thickness of at least one said separation layer lying in the range 1 microns to 4 microns.

**9.** A resonator according to any one of claims 1 to 8, the second crystal plane being different from and not equivalent to the first crystal plane.

**10.** A resonator according to any one of claims 1 to 8, the second crystal plane being identical to or equivalent to the first crystal plane, the crystal direction of the first layer being offset by the angle (a) different from 0°, 45°, or 180° from any equivalent crystal direction of the second layer, the orientations of the crystal lattices of said first and second layers of silicon thus being different.

**11.** A resonator according to any one of claims 1 to 10, comprising more than two layers of silicon mutually separated by at least one separation layer.

**12.** A resonator according to any one of claims 1 to 11, having a plurality of said separation layers between the layers of silicon.

**13.** A resonator according to any one of claims 1 to 12, further comprising an outer layer made of a material having a thermal coefficient of Young's modulus of opposite sign from the thermal coefficient of Young's modulus of silicon.

**14.** A method of manufacturing a mechanical resonator according to any one of claims 1 to 13, comprising depositing a separation layer on a silicon wafer, and then etching a plurality of mechanical resonators in said wafer.

**15.** The method of claim 14, further comprising depositing a second layer of silicon on the separation layer, the mechanical resonators being cut out after this deposition.

**16.** The method of claim 14, further comprising depositing a second layer of silicon on the separation layer, after said step of etching the mechanical resonators.

EP 3 285 124 B1

Fig. 1

Fig. 2

Fig. 3

Fig. 4

Fig. 5

EP 3 285 124 B1

Fig. 6

EP 3 285 124 B1

Fig. 7

EP 3 285 124 B1

Fig. 8

Fig. 9

Fig. 10

Fig. 11A                    Fig. 11B                    Fig. 11C

Fig. 12

EP 3 285 124 B1

EP 3 285 124 B1

Fig. 13

Ci2 — — Cs2    double-SOI

Cs1 — — Ci1

— Su1

41

Ci1

— Su1

42

Ci2 — — Cs2

Cs1 —    ← 1

Fig. 14

EP 3 285 124 B1

Fig. 15

27

EP 3 285 124 B1

Fig. 16

Fig. 17

EP 3 285 124 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1422436 A
- EP 2215531 A
- EP 1904901 A
- CH 699780